# EUROPEAN PATENT APPLICATION

(11) **EP 3 540 447 A1**
(43) Date of publication of application: **18.09.2019**
(21) Application number: 19162652.2
(22) Date of filing: 13.03.2019
(51) Int. Cl.: G01R 13/00, G01R 31/319

(54) **TEST AND MEASUREMENT MANAGEMENT**

(30) Priority: 13.03.2018 US 201862642008 P; 31.08.2018 US 201816119248
(71) Applicant: Tektronix, Inc., Beaverton, OR 97077-0001 (US)
(72) Inventor: PEETERS WEEM, Jan, Forest Grove, OR 97116 (US)
(74) Representative: HGF Limited

(57) **Abstract**

A test and measurement management device, including a request queue to receive a request from a request module, the request including an identification of a device under test and a requested measurement and one or more processors. The one or more processors are configured to receive the request from the request queue, generate a command to instruct an optical switch to select a port associated with the device under test based on the identification of the device under test, determine the requested measurement from the request, and based on the requested measurement and the identification of the device under test, generate instructions to configure a test and measurement instrument to perform the requested measurement.

## Description

### PRIORITY

This disclosure claims benefit of U.S. Provisional Application No. 62/642,008, titled "MULTI-LANE SERIALIZED SIGNAL ACQUISITION," filed on March 13, 2018, which is incorporated herein by reference in its entirety.

### FIELD OF THE INVENTION

This disclosure is directed to systems and methods related to test and measurement systems, and in particular, to a test and measurement management system having an optical switch to connect a number of devices under test to a test and measurement instrument, and a test and measurement device to control the test and measurement system to retrieve a measurement from each of the devices under test through the switch.

### BACKGROUND

There are many environments, such as manufacturing environments, that may need to measure signals from a plurality of devices under test to determine how the devices under test are performing within the environment. Traditionally, this may be done by using a sampling oscilloscope and connecting each device under test to a different channel of the sampling oscilloscope. This can also be done by connecting each device under test to a different sampling oscilloscope.

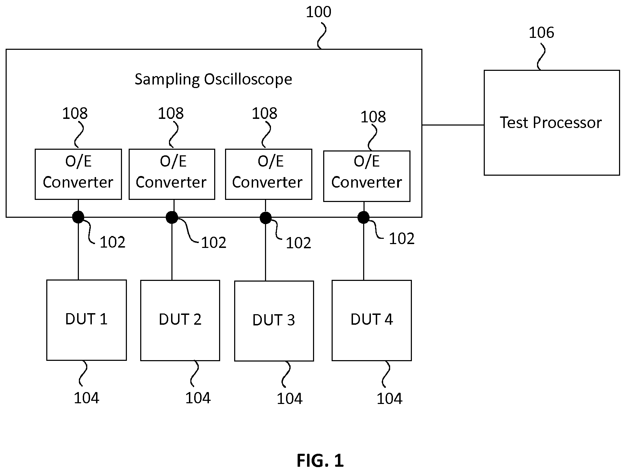

Fig. 1 is a block diagram of a traditional test and measurement system in which optical signals are characterized in a manufacturing environment. A sampling oscilloscope 100 has four channels 102. Each channel 102 is connected to a respective device under test (DUT) 104. The sampling oscilloscope 100 may be connected to a test processor 106, the test processor 106 associated with at least one of the four DUTs 104 illustrated. Each channel 102 of the sampling oscilloscope 100 includes a high-cost optical to electrical (O/E) converter 108. Adding channels with O/E converters 108 to a sampling oscilloscope can be costly.

Since sampling oscilloscopes must also have access to a clock that is synchronous to the measured data. The clock may be determined using a clock recovery module or a subrate clock may be provided by a user. However, if the data rate for each DUT is different, then it may be necessary to use multiple sampling oscilloscopes due to the different clocks that have to be synchronized to the data, rather than multiple channels of one sampling oscilloscope, which can be costly.

Embodiments of the disclosure address these and other deficiencies of the prior art.

### BRIEF DESCRIPTION OF THE DRAWINGS

Aspects, features, and advantages of embodiments of the present disclosure will become apparent from the following description of embodiments in reference to the appended drawings in which:
Fig. 1 illustrates a block diagram of a conventional test and measurement system for measuring optical signals from a number of devices under test.
Fig. 2 illustrates a block diagram of a test and measurement system for measuring optical signals from a number of devices under test according to some embodiments of the disclosure.
Fig. 3 is a flow chart illustration an operation of the test and measurement system of Fig. 2.
Fig. 4 is a block diagram of a test and measurement system having a calibration device.
Fig. 5 is a flow chart illustrating an operation of the test and measurement system of Fig. 4.

### DESCRIPTION

Disclosed herein is a test and measurement system having a test and measurement management module to control various components of the test and measurement system. The test and measurement management module may receive a request for a measurement from a request device. The test and measurement management device may include a request queue to receive the request and store the request in the request queue. The test and measurement management device may include one or more processors to receive the request, and based on the request, generate and send instructions to a test and measurement instrument to configure itself to take a measurement from a device under test based on the request. Further, the test and measurement management device may generate and send instructions to an optical switch to select a port associated with a device under test that is identified in the request. Such a system allows several devices under to test to be connected to a single input channel of a test and measurement instrument via an optical switch, rather than having to connect each device under test to a separate channel of the test and measurement instrument or to individual test and measurement instruments.

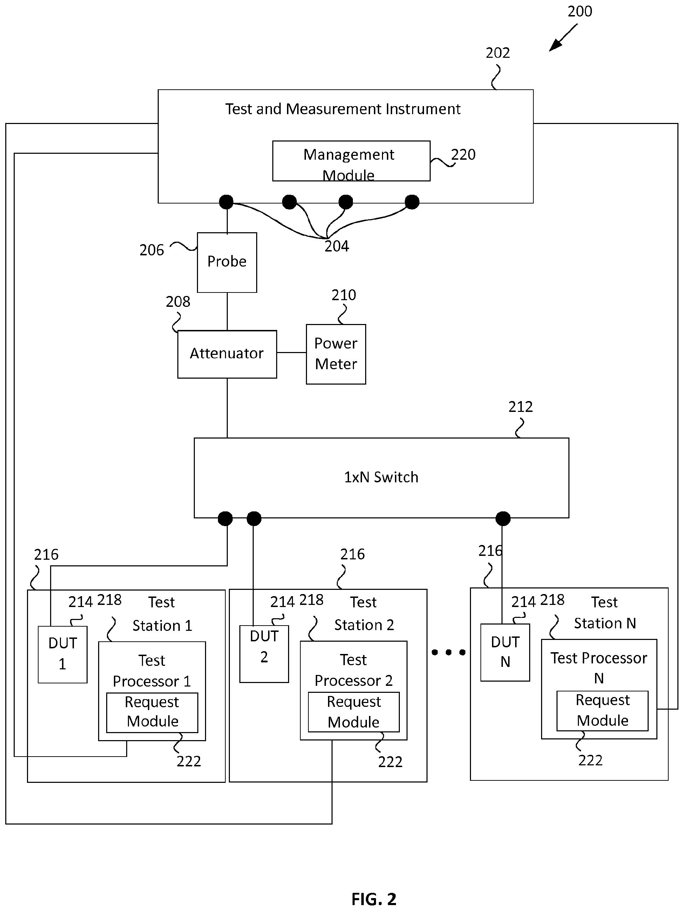

Fig. 2 illustrates a block diagram of a test and measurement system 200 according to some embodiments herein. The test and measurement system 200 of Fig. 2 includes a real-time test and measurement instrument 202, such as a real-time oscilloscope. As will be understood by one skilled in the art, the real-time test and measurement instrument 202 may include a variety of components not illustrated in Fig. 2, however these components have been omitted in the interest of clarity. For example, the test and measurement instrument 202 may include a user interface, one or more processors to process data, one or more controllers to control various components of the test and measurement instrument 202, as well as one or more memories, among many other potential components, as would be understood by one skilled in the art.

The real-time test and measurement instrument 202 may also include one or more input channels 204. A probe 206 may be connected to one of the channels 204. The probe 206 may be connected to an attenuator 208, which may be further connected to a power meter 210. In some embodiments, the attenuator 208 may be replaced with an amplifier or the probe 206 may also be coupled to an amplifier (not shown). The channel 204 connected to the probe may contain an O/E converter (not shown).

The attenuator 208 may be connected to an optical switch 212. The optical switch 212 may have N connections or ports, to connect to up to N DUTs 214, which may be included in various test stations 216. Each test station 216 may have an associated test processor 218. Although the test processor 218 and DUT 214 are shown located in a test station 216, the devices do not have to be physically located next to each other, but rather the DUTs 214 and the test processors 218 are each respectively associated with each other, forming a test station 216.

Further, while Fig. 2 depicts that there are N switch connections in the optical switch 212, and potentially N test stations 216, each with an associated DUT 214 and test processor 218, it will be appreciated that the number of test processors 218 need not necessarily correlate with the number of DUTs 214. Rather, one test processor 218 could be associated with multiple test stations 216 and multiple DUTS 214.

The test and measurement system 200 of Fig. 2, allows a single channel 204 on the test and measurement instrument 202 to be utilized to capture waveforms from a plurality of connected DUTs 214 utilizing a single O/E converter. This can be especially beneficial in a manufacturing environment; however, it will be appreciated that such a configuration could be utilized in any number of other environments as well.

As an example, as mentioned above, manufacturing customers currently use multiple equivalent time oscilloscopes to make measurements on a manufacturing line. Configurations in accordance with this disclosure can save manufacturers money by utilizing a single real-time oscilloscope to make the same measurements. In addition, because of the performance of optical switches, the configuration of Fig. 2 can switch between ports of the optical switch 212 with very little loss. This is the case even at high speeds.

The configuration disclosed herein can also enable new functionality, for example, using a real-time test and measurement instrument 202 provides an advantage that no-clock architecture is required. As mentioned above, sampling oscilloscopes have always needed to have access to a clock that is synchronous to the measured data. By using real-time test and measurement instrument 202, no clock is required, and multiple signals having different data rates can be acquired on the same real-time test and measurement instrument 202. The clock of the signal can then be recovered by either a processor in the test and measurement instrument 202 or a test processor 218 associated with the DUT 214 as part of post-processing of the data.

In addition, it will be appreciated that, in some configurations, the test and measurement instrument 202 could be replaced with an analog-to-digital converter (ADC) device that can produce a digitized version of a captured waveform to be transmitted to the test processor 218.

The test and measurement system 200 may also include a management module 220 and/or one or more request modules 222. As shown in Fig. 2, the management module 220 may be incorporated into the test and measurement instrument 202 while a requesting module 222 maybe incorporated into each test processor 218. However, as will be understood by one skilled in the art, the management device 220 and/or the request device 222 may alternatively be integrated into separate computing devices, such as one or more controllers, that could act as coordinators between the test and measurement instrument 202 and the optical switch 212. In other instances, the request device 222 may alternatively be included in the test and measurement instrument 202, or may be included as a separate component of the test station 216, while the management device 220 is included in either the test and measurement instrument 202 or a controller. That is, multiple request devices 222 may be provided in the test and measurement system 200, each request device 222 associated with or incorporated in a respective test processor 218.

The request device 222 can be configured to receive a request, such as from a user interface or any other source, indicating a desire to capture a waveform from a selected DUT 214. The request may include an identifier associated with the selected DUT 214 or the channel 204 with which the DUT 214 is coupled. For example, the request could include a unique identifier of the DUT 214, which could be correlated, such as by a table or other data source, with a port on the optical switch 212. Such a table, for example, may be established by a user of the test and measurement system 200 either through a user interface of the device that includes the request device 222, such as the test and measurement instrument 202, a controller, or the test processor 218.

In some embodiments, the request may also include various additional requirements for the desired measurement, such as a desired duration, an indicator of a specific trigger to be utilized in identifying the waveform, desired de-embed parameters, any other requirements for the measurement, or additional designations for the request, such as a priority designation. The request device 222 can be configured to forward or transmit this information to the management device 220, either through a wired or wireless connection. Further, in some embodiments, the request may include priority information for the measurement.

The management device 220 can be configured to receive the request information from the request device 222 and can generate instructions to cause the optical switch 212 to switch to the port associated with the DUT 214 identified in the request so that the test and measurement instrument 202 can capture the waveform also requested in the request. As will be discussed in more detail below, the management device 220 may be configured to generate instructions to configure the test and measurement instrument 202, or any other configurable component of the test and measurement system 200, to capture the measurement and/or waveform requested. The test and measurement instrument 202 may process the waveform or measurement itself, or the test and measurement instrument 202 may transmit the captured waveform or measurement to the test processor 218 associated with the DUT 214 to free resources for the next measurement in a request queue.

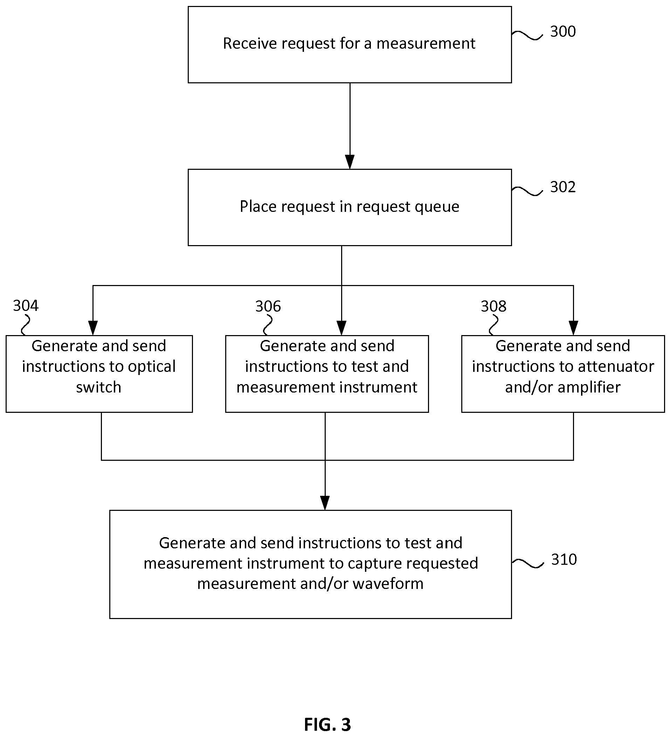

Fig. 3 illustrates an operation of the management device 220 in the test and measurement system 200 according to some embodiments disclosed herein. In operation 300, the management device 220 receives a request for a measurement from the request device 222. In some embodiments, the management device 220 may include a request queue and in operation 302, the request is placed in the request queue when the request cannot be serviced in real time. In such instances, the management device 220 can place the request in the request queue, and then the management device 220 can iterate through the request queue servicing each request in order, as will be discussed in more detail below.

In some embodiments, the request queue could be configured to list the requests in the order in which the requests are received, such as a first-in first-out (FIFO) queue. In other embodiments, especially when the requests have varying degrees of priority, the request queue and/or the management device 220 could be configured to take into account the priority assigned to the request such that the requests are processed in order of an assigned priority. In such embodiments, any request received without a priority could be prioritized in the order in which requests were received.

In operation 304, the management device 220 may be configured to generate and send instructions to the optical switch 212 to select the port associated with the identified DUT 212 in the request. In operation 306, the management device 220 may be configured to generate and send instructions to the test and measurement instrument 202 that instruct the test and measurement instrument 202 to configure itself to obtain the measurement requested in the request. In operation 308, the management device 220 may be configured to generate and send instructions to the attenuator 208 and/or an amplifier to configure itself for the requested measurement and/or waveform to be captured. The attenuator 208 and/or amplifier may receive the instructions and automatically adjust its settings based on the instructions. The instructions may indicate which port of optical switch 212 the measurement is being obtained from to increase the signal-to-noise (SNR) ratio and/or the dynamic range for the test and measurement instrument 202. In some embodiments, these adjustments may take into account the effects of the connection between the optical switch 212 and the DUT 214. As will be understood by one skilled in the art, although operations 304, 306, and 308 are shown as occurring one after the other, the operations may be performed in an overlapping manner or in an order different from that shown in Fig. 3.

In operation 310, the management device 220 may be configured to generate and send instructions to the test and measurement instrument 202 to capture the requested waveform or measurement once the test and measurement instrument 202 and other configurable components are appropriately configured. The test and measurement instrument 202 can then measure the signal of the connected DUT 214. The test and measurement instrument 202 may be configured to process the captured waveform or measurement from the DUT 214 connected through the optical switch 212 and/or the test and measurement instrument 202 may be configured to transmit the measurement and/or waveform to a respective test processor 218 at the respective test station 216 for processing. Data transmitted with the measurement may include, for example, the waveform, system noise, system calibration, and other required data.

In some embodiments of the disclosure, a calibration device may be used to calibrate the test and measurement system 200. The calibration device may be, for example, a National Institute of Standards and Technology (NIST) traceable, or foreign equivalent, calibration device. The calibration device may be connected to any one of the channels 204 of the test and measurement instrument 202 or may be connected any one of the ports of the optical switch 212. When connected to the test and measurement instrument 202 either directly through one of the channels 204 or through a port on the optical switch 212, the remaining channels 204 of the test and measurement instrument 202 may continue to run while the channel 204 connected to the calibration device is calibrated.

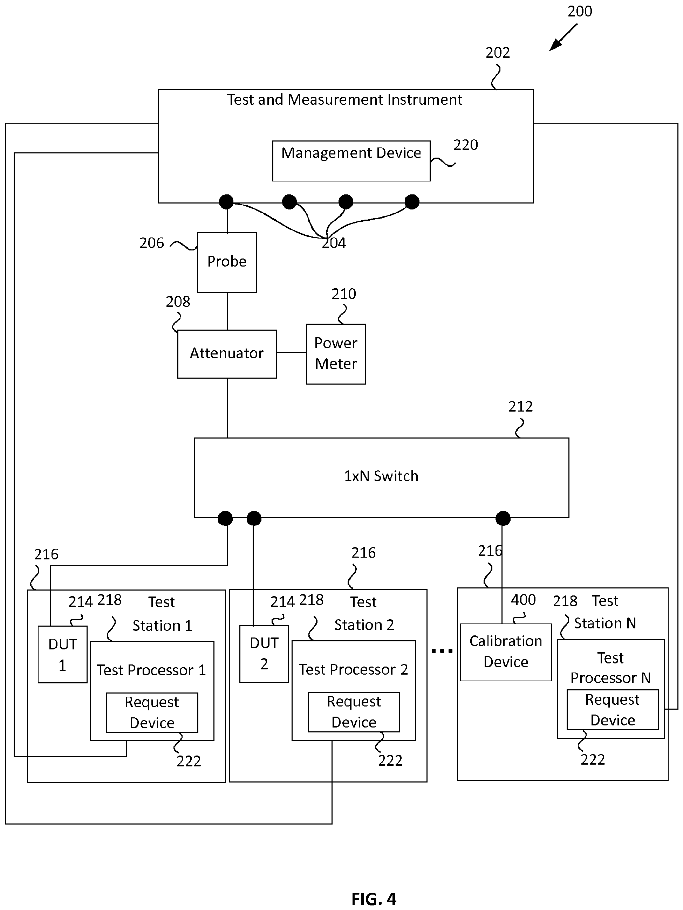

Fig. 4 illustrates an example calibration device 400 that can be connected to one of the ports of the switch 212. A measurement is taken through the test and measurement instrument 202 based on an output from the calibration device 400. Since the output of the calibration device 400 is known, one of the processors in the test and measurement system 200, such as a processor of the test and measurement instrument 202 or a test processor 218 can determine calibration parameters for various components within the test and measurement system 200 and the calibration parameters may either be saved in a memory of the test and measurement instrument 202, the management device 220, or the test processor 218. When saved in a memory associated with the test processor 218, the test processor 218 may include in the request for a measurement the relevant calibration data received during the calibration test.

For example, in some embodiments of the disclosure, the calibration device 400 may be an impulse source or a constant wave source, for example. Embodiments of the disclose, however, are not limited to an impulse source or a constant wave source and may be any type of calibration device that produces a known output. Since these sources are known, the known input can be compared to the measured signal by the test and measurement instrument 202 and calibration parameters may be derived for the system. These parameters may be used to configure various components of the test and measurement instrument 202, as well as the attenuator. Further, the power meter 210 may be used during calibration to measure the system loss based on the known calibration signal.

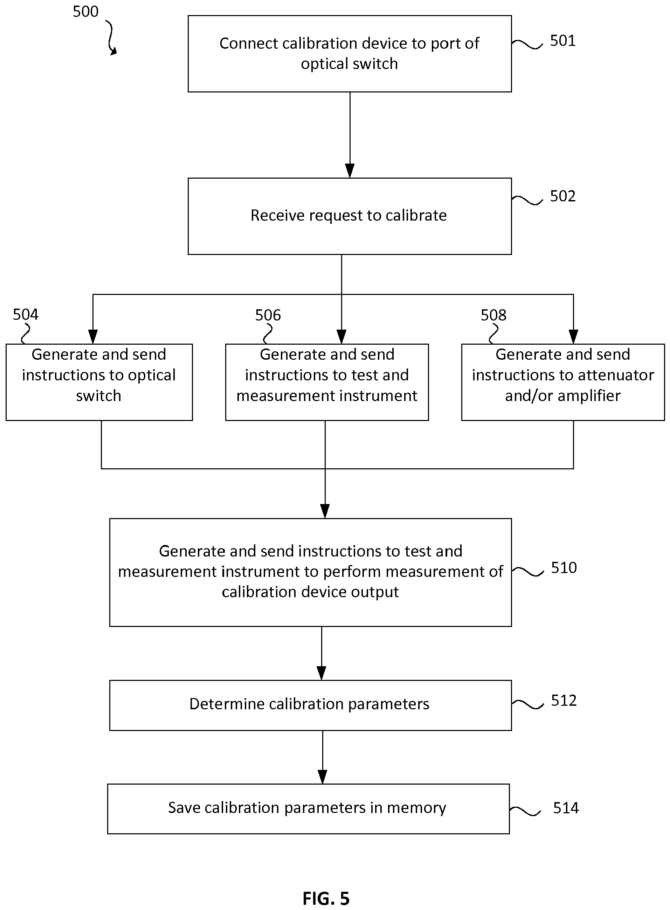

Fig. 5 illustrates an example operation 500 for calibrating the test and measurement instrument 202. Within this example operation 500, at operation 501, the calibration device is connected to a port of the optical switch 212. However, as will be readily understood by one skilled in the art, a similar example calibration can be performed when the calibration device 400 is connected directly to the test and measurement instrument 202.

[0033][0034] At operation 502, the management device 220 may receive a request to calibrate either from the request queue, from a test processor 218 associated with the calibration device 400, or from a user input. At operations 504, 506, and 508, the management device 220 may generate and send instructions to respectively configure each of the optical switch 212, the test and measurement instrument 202, and the attenuator/amplifier for a calibration measurement. As one of ordinary skill in the art would understand, the management device 220 may also generate and send instructions to configure the power meter 210 for a calibration measurement. In operation 510, the management device 220 generates and sends instructions to the test and measurement instrument 202 to perform a variety of measurements when the calibration device 400 is connected through the switch 212 to the test and measurement instrument 202. At operation 512, calibration parameters may be established for each port of the optical switch 212, by connecting the calibration device 400 to each port and performing various calibration procedures discussed above to determine the calibration parameters. At operation 514, calibration parameters for each port of the optical switch 212 may then be saved in a memory, such as a memory in the test and measurement system 200.

In some embodiments, a port of the optical switch 212 may be continuously connected to the calibration device 400 while at least a portion of the remaining ports are connected to various DUTS 214. The management device 220 may then generate instructions to periodically perform a measurement of the calibration device to check and/or update the calibration parameters currently saved in a memory.

Aspects of the disclosure may operate on particularly created hardware, firmware, digital signal processors, or on a specially programmed computer including a processor operating according to programmed instructions. The terms controller or processor as used herein are intended to include microprocessors, microcomputers, Application Specific Integrated Circuits (ASICs), and dedicated hardware controllers. One or more aspects of the disclosure may be embodied in computer-usable data and computer-executable instructions, such as in one or more program modules, executed by one or more computers (including monitoring modules), or other devices. Generally, program modules include routines, programs, objects, components, data structures, etc. that perform particular tasks or implement particular abstract data types when executed by a processor in a computer or other device. The computer executable instructions may be stored on a computer readable storage medium such as a hard disk, optical disk, removable storage media, solid state memory, Random Access Memory (RAM), etc. As will be appreciated by one of skill in the art, the functionality of the program modules may be combined or distributed as desired in various aspects. In addition, the functionality may be embodied in whole or in part in firmware or hardware equivalents such as integrated circuits, FPGA, and the like. Particular data structures may be used to more effectively implement one or more aspects of the disclosure, and such data structures are contemplated within the scope of computer executable instructions and computer-usable data described herein.

The disclosed aspects may be implemented, in some cases, in hardware, firmware, software, or any combination thereof. The disclosed aspects may also be implemented as instructions carried by or stored on one or more or computer-readable storage media, which may be read and executed by one or more processors. Such instructions may be referred to as a computer program product. Computer-readable media, as discussed herein, means any media that can be accessed by a computing device. By way of example, and not limitation, computer-readable media may comprise computer storage media and communication media.

Computer storage media means any medium that can be used to store computer-readable information. By way of example, and not limitation, computer storage media may include RAM, ROM, Electrically Erasable Programmable Read-Only Memory (EEPROM), flash memory or other memory technology, Compact Disc Read Only Memory (CD-ROM), Digital Video Disc (DVD), or other optical disk storage, magnetic cassettes, magnetic tape, magnetic disk storage or other magnetic storage devices, and any other volatile or nonvolatile, removable or non-removable media implemented in any technology. Computer storage media excludes signals per se and transitory forms of signal transmission.

Communication media means any media that can be used for the communication of computer-readable information. By way of example, and not limitation, communication media may include coaxial cables, fiber-optic cables, air, or any other media suitable for the communication of electrical, optical, Radio Frequency (RF), infrared, acoustic or other types of signals.

Examples of the disclosure may operate on a particularly created hardware, on firmware, digital signal processors, or on a specially programmed computer including a processor operating according to programmed instructions. The terms "controller" or "processor" as used herein are intended to include microprocessors, microcomputers, ASICs, and dedicated hardware controllers. One or more aspects of the disclosure may be embodied in computer-usable data and computer-executable instructions, such as in one or more program modules, executed by one or more computers (including monitoring modules), or other devices. Generally, program modules include routines, programs, objects, components, data structures, etc. that perform particular tasks or implement particular abstract data types when executed by a processor in a computer or other device. The computer executable instructions may be stored on a computer readable storage medium such as a hard disk, optical disk, removable storage media, solid state memory, RAM, etc. As will be appreciated by one of skill in the art, the functionality of the program modules may be combined or distributed as desired in various examples. In addition, the functionality may be embodied in whole or in part in firmware or hardware equivalents such as integrated circuits, field programmable gate arrays (FPGA), and the like. Particular data structures may be used to more effectively implement one or more aspects of the disclosure, and such data structures are contemplated within the scope of computer executable instructions and computer-usable data described herein.

Aspects of the present disclosure operate with various modifications and in alternative forms. Specific aspects have been shown by way of example in the drawings and are described in detail herein below. However, it should be noted that the examples disclosed herein are presented for the purposes of clarity of discussion and are not intended to limit the scope of the general concepts disclosed to the specific examples described herein unless expressly limited. As such, the present disclosure is intended to cover all modifications, equivalents, and alternatives of the described aspects in light of the attached drawings and claims.

References in the specification to embodiment, aspect, example, etc., indicate that the described item may include a particular feature, structure, or characteristic. However, every disclosed aspect may or may not necessarily include that particular feature, structure, or characteristic. Moreover, such phrases are not necessarily referring to the same aspect unless specifically noted. Further, when a particular feature, structure, or characteristic is described regarding a particular aspect, such feature, structure, or characteristic can be employed in connection with another disclosed aspect whether or not such feature is explicitly described in conjunction with such other disclosed aspect.

The disclosed aspects may be implemented, in some cases, in hardware, firmware, software, or any combination thereof. The disclosed aspects may also be implemented as instructions carried by or stored on one or more or computer-readable media, which may be read and executed by one or more processors. Such instructions may be referred to as a computer program product. Computer-readable media, as discussed herein, means any media that can be accessed by a computing device. By way of example, and not limitation, computer-readable media may comprise computer storage media and communication media.

Computer storage media means any medium that can be used to store computer-readable information. By way of example, and not limitation, computer storage media may include Random Access Memory (RAM), Read Only Memory (ROM), Electrically Erasable Programmable Read-Only Memory (EEPROM), flash memory or other memory technology, Compact Disc Read Only Memory (CD-ROM), Digital Video Disc (DVD), or other optical disk storage, magnetic cassettes, magnetic tape, magnetic disk storage or other magnetic storage devices, and any other volatile or nonvolatile, removable or non-removable media implemented in any technology. Computer storage media excludes signals per se and transitory forms of signal transmission.

Communication media means any media that can be used for the communication of computer-readable information. By way of example, and not limitation, communication media may include coaxial cables, fiber-optic cables, air, or any other media suitable for the communication of electrical, optical, Radio Frequency (RF), infrared, acoustic or other types of signals.

Illustrative examples of the technologies disclosed herein are provided below. An embodiment of the technologies may include any one or more, and any combination of, the examples described below.
Example 1 is a test and measurement management device, comprising a request queue to receive a request from a request module, the request including an identification of a device under test and a requested measurement; and one or more processors configured to receive the request from the request queue, generate a command to instruct an optical switch to select a port associated with the device under test based on the identification of the device under test, determine the requested measurement from the request, and based on the requested measurement and the identification of the device under test, generate instructions to configure a test and measurement instrument to perform the requested measurement.
Example 2 is the test and measurement management device of example 1, wherein the one or more processors are further configured to generate instructions to configure an attenuator connected to the optical switch and the test and measurement instrument based on at least one of the identification of the device under test or the requested measurement.
Example 3 is the test and measurement management device of either one of examples 1 or 2, wherein the one or more processors are further configured to generate instructions to configure an amplifier connected to the optical switch and the test and measurement instrument based on at least one of the identification of the device under test or the requested measurement.
Example 4 is the test and measurement management device of any one of examples 1-3, wherein the request includes priority information, and one or more processors are further configured to place the request in the request queue based on the priority information.
Example 5 is the test and measurement management device of any one of examples 1-4, wherein the request queue is a first in first out request queue.
Example 6 is the test and measurement management device of any one of examples 1-5, wherein the request includes at least one of a desired duration of the measurement, a trigger indicator, de-embed parameters, or configuration parameters.
Example 7 is a method for operating a test and management system, the method comprising receiving a request from a request queue, the request including an identification of a device under test and a requested measurement; generating a command to instruct an optical switch to select a port associated with the device under test based on the identification of the device under test, determining the requested measurement from the request; and based on the requested measurement and the identification of the device under test, generating instructions to configure a test and measurement instrument to perform the requested measurement.
Example 8 is the method of example 7, wherein the one or more processors are further configured to generate instructions to configure an attenuator connected to the optical switch and the test and measurement instrument based on at least one of the identification of the device under test or the requested measurement.
Example 9 is the method of either of examples 7 or 8, wherein the one or more processors are further configured to generate instructions to configure an amplifier connected to the optical switch and the test and measurement instrument based on at least one of the identification of the device under test or the requested measurement.
Example 10 is the method of any one of examples 7-9, wherein the request includes priority information, and one or more processors are further configured to place the request in the request queue based on the priority information.
Example 11 is the method of any one of examples 7-10, wherein the request queue is a first in first out request queue.
Example 12 is the method of any one of examples 7-11, wherein the request includes at least one of a desired duration of the measurement, a trigger indicator, de-embed parameters, or configuration parameters.
Example 13 is the method of any one of examples 7-12, further comprising receiving a calibration signal and determining at least one calibration parameter based on the calibration signal.
Example 14 is the method of example 13, further comprising storing the at least one calibration parameter associated with the selected port of the optical switch.
Example 15 is a test and measurement system, the test and measurement system comprising a real-time test and measurement instrument, the real-time test and measurement instrument including an input channel configured to receive an optical signal, and an optical-to-electrical converter connected to the channel; an optical switch electrically connected to the real-time test and measurement instrument, the optical switching included a number of input ports, each input port of at least a portion of the input ports is configured to electrically connect to a device under test; and a test and measurement management device having one or more processors configured to receive a measurement request, the request including an identification of the device under test associated with one of the input ports of the optical switch and a requested measurement, generate a command to instruct the optical switch to select the input port associated with the device under test based on the identification of the device under test, determine the requested measurement from the request, and based on the requested measurement and the identification of the device under test, generate instructions to configure the test and measurement instrument to perform the requested measurement.
Example 16 is the test and measurement system of example 15, further comprising a calibration device configured to electrically connect to at least one of the input ports, wherein a processor of the test and measurement system is configured to receiving a signal from the calibration device and determine calibration parameters based on the signal from the calibration device.
Example 17 is the test and measurement system of either one of examples 15 and 16, further comprising a configurable attenuator, wherein the one or more processors of the management device are further configured to generate instructions to configure the attenuator based on the requested measurement.
Example 18 is the test and measurement system of any one of examples 15-17, wherein the test and measurement management device is included in the test and measurement instrument.
Example 19 is the test and measurement system of any one of examples 15-18, further comprising a request device configured to generate a request to send to the test and measurement management device.
Example 20 is the test and measurement system of example 19, wherein the request device is included in a test processor associated with the device under test.

The previously described versions of the disclosed subject matter have many advantages that were either described or would be apparent to a person of ordinary skill. Even so, these advantages or features are not required in all versions of the disclosed apparatus, systems, or methods.

Additionally, this written description makes reference to particular features. It is to be understood that the disclosure in this specification includes all possible combinations of those particular features. Where a particular feature is disclosed in the context of a particular aspect or example, that feature can also be used, to the extent possible, in the context of other aspects and examples.

Also, when reference is made in this application to a method having two or more defined steps or operations, the defined steps or operations can be carried out in any order or simultaneously, unless the context excludes those possibilities.

Although specific examples of the invention have been illustrated and described for purposes of illustration, it will be understood that various modifications may be made without departing from the scope of the invention. Accordingly, the invention should not be limited except as by the appended claims.

## Claims

1. A test and measurement management device, comprising:
a request queue to receive a request from a request module, the request including an identification of a device under test and a requested measurement; and
one or more processors configured to:
receive the request from the request queue,
generate a command to instruct an optical switch to select a port associated with the device under test based on the identification of the device under test,
determine the requested measurement from the request, and
based on the requested measurement and the identification of the device under test, generate instructions to configure a test and measurement instrument to perform the requested measurement.

2. The test and measurement management device of claim 1, wherein the one or more processors are further configured to generate instructions to configure an attenuator connected to the optical switch and the test and measurement instrument based on at least one of the identification of the device under test or the requested measurement.

3. The test and measurement management device of claim 1 or 2, wherein the one or more processors are further configured to generate instructions to configure an amplifier connected to the optical switch and the test and measurement instrument based on at least one of the identification of the device under test or the requested measurement.

4. The test and measurement management device of any of claims 1 to 3, wherein the request includes priority information, and one or more processors are further configured to place the request in the request queue based on the priority information.

5. The test and measurement management device of any of claims 1 to 4, wherein the request queue is a first in first out request queue; and/or
wherein the request includes at least one of a desired duration of the measurement, a trigger indicator, de-embed parameters, or configuration parameters.

6. A method for operating a test and management system, the method comprising:
receiving a request from a request queue, the request including an identification of a device under test and a requested measurement;
generating a command to instruct an optical switch to select a port associated with the device under test based on the identification of the device under test;
determining the requested measurement from the request; and
based on the requested measurement and the identification of the device under test, generating instructions to configure a test and measurement instrument to perform the requested measurement.

7. The method of claim 6, wherein the one or more processors are further configured to generate instructions to configure an attenuator connected to the optical switch and the test and measurement instrument based on at least one of the identification of the device under test or the requested measurement.

8. The method of claim 6 or 7, wherein the one or more processors are further configured to generate instructions to configure an amplifier connected to the optical switch and the test and measurement instrument based on at least one of the identification of the device under test or the requested measurement.

9. The method of any of claims 6 to 8, wherein the request includes priority information, and one or more processors are further configured to place the request in the request queue based on the priority information.

10. The method of any of claims 6 to 9, wherein the request queue is a first in first out request queue; and/or
wherein the request includes at least one of a desired duration of the measurement, a trigger indicator, de-embed parameters, or configuration parameters.

11. The method of any of claims 6 to 10, further comprising receiving a calibration signal and determining at least one calibration parameter based on the calibration signal; and optionally further comprising storing the at least one calibration parameter associated with the selected port of the optical switch.

12. A test and measurement system, the test and measurement system comprising:
a real-time test and measurement instrument, the real-time test and measurement instrument including:
an input channel configured to receive an optical signal, and
an optical-to-electrical converter connected to the channel;
an optical switch electrically connected to the real-time test and measurement instrument, the optical switching included a number of input ports, each input port of at least a portion of the input ports is configured to electrically connect to a device under test; and
a test and measurement management device having one or more processors configured to:
receive a measurement request, the request including an identification of the device under test associated with one of the input ports of the optical switch and a requested measurement,
generate a command to instruct the optical switch to select the input port associated with the device under test based on the identification of the device under test,
determine the requested measurement from the request, and
based on the requested measurement and the identification of the device under test, generate instructions to configure the test and measurement instrument to perform the requested measurement.

13. The test and measurement system of claim 12, further comprising a calibration device configured to electrically connect to at least one of the input ports, wherein a processor of the test and measurement system is configured to receiving a signal from the calibration device and determine calibration parameters based on the signal from the calibration device.

14. The test and measurement system of claim 12 or 13, further comprising a configurable attenuator, wherein the one or more processors of the management device are further configured to generate instructions to configure the attenuator based on the requested measurement; and/or
wherein the test and measurement management device is included in the test and measurement instrument.

15. The test and measurement system of any of claims 12 to 14, further comprising a request device configured to generate a request to send to the test and measurement management device; and optionally
wherein the request device is included in a test processor associated with the device under test.
